# EUROPEAN PATENT SPECIFICATION

(11) **EP 4 383 976 B1**
(45) Date of publication and mention of the grant of the patent: **20.08.2025**
(21) Application number: 21952858.5
(22) Date of filing: 06.08.2021
(51) Int. Cl.: H05K 13/04, B25J 15/08, B25J 15/00, B25J 15/02

(54) **GRIPPING MECHANISM**
GREIFMECHANISMUS
MÉCANISME DE PRÉHENSION

(43) Date of publication of application: 12.06.2024
(73) Proprietor: Fuji Corporation, Chiryu-shi, Aichi 472-8686 (JP)
(72) Inventor: MORI, Kazuaki, Chiryu-shi, Aichi 472-8686 (JP)
(74) Representative: Grünecker Patent- und Rechtsanwälte PartG mbB
(86) International application number: PCT/JP2021/029319
(87) International publication number: WO 2023/013035

(56) References cited:
- WO-A1-2019/102923
- WO-A1-2020/116401
- JP-A- 2002 151 890
- JP-A- 2002 355 786
- JP-A- 2002 355 786
- JP-A- 2006 086 270
- JP-A- H02 224 992

## Description

### Technical Field

The present description discloses a gripping mechanism.

### Background Art

Conventionally, there has been proposed a gripping mechanism for a component including a pair of gripping claws configured to grip a component, an opening and closing device for opening and closing the pair of gripping claws, and a block-shaped strip that abuts against an upper surface of the component (for example, refer to WO 2018/051451 A1). In this gripping mechanism, it is described that an attaching surface for a strip is provided substantially in the center of the opening and closing device, and a strip according to the size of a component among multiple types of strips is attached on the attaching surface, or an upper surface of the component is abutted against the strip and gripped by the gripping claws, whereby the component can be gripped in a correct posture. Such strip is also used for push-in, when the component having a lead below is pushed in from above and the lead is inserted into the insertion hole of the board. Clamp surfaces of gripping claws disclosed in JP 2002 355786 A are slightly inclined with respect to the vertical surface when no component is held. The gripping claws are elastically deformed when a component is gripped, so that the clamp surfaces become substantially vertical, and lower surfaces of protrusions provided at an angle of slightly more than 90 degrees with respect to the clamp surfaces push the upper surface of the component.

### Summary of the Invention

### Technical Problem

In WO 2018/051451 A1 described above, since it is necessary to secure a space for attaching a strip to the opening and closing device, the opening and closing device may be increased in size. In addition, since it is necessary to exchange the strip according to the size of the component, exchange operation may take time and affect the production.

A main object of the present disclosure is to provide a gripping mechanism that does not need to secure a space for attaching a strip in an opening and closing device and can reduce exchange operation by enhancing versatility of the strip.

### Solution to Problem

The present disclosure employs a gripping mechanism as defined in the appended claims in order to achieve the main object described above.

In the gripping mechanism of the present disclosure, the strip is configured to move integrally with the gripping claw, and is configured such that the abutment portion protrudes in the closing direction with respect to the gripping surface of the gripping claw in the open state where the multiple gripping claws are spaced apart from each other. Accordingly, it is not necessary to secure a space for attaching a strip in the opening and closing device. In addition, even when the gripping claws move to any positions according to the size of the component to be gripped, since the abutment portion protrudes with respect to the gripping surface, the abutment portion of the strip can be abutted against an upper surface of the component regardless of the size of the component. Therefore, the versatility of the strip can be enhanced, and the exchange operation of the strip can be reduced. Furthermore, the abutment portion is embedded in the gripping surface when a component is gripped, so that it is possible to grip the component in any area of the gripping surface, regardless of the strip.

### Brief Description of Drawings

Fig. 1 is a configuration diagram illustrating a schematic configuration of work system 10
Fig. 2 is a block diagram illustrating an electrical connection relationship of work system 10.
Fig. 3 is a perspective view of component chuck device 30.
Fig. 4 is a front view of gripping mechanism 40.
Fig. 5 is a side view of gripping mechanism 40.
Fig. 6 is a front view of gripping claw 45 integrated with strip 50.
Fig. 7 is an exploded perspective view of gripping claw 45 and strip 50.
Fig. 8 is a view illustrating a state of gripping mechanism 40 when gripping claws 45 are in a closed state.
Fig. 9 is a view illustrating a state where gripping mechanism 40 grips lead component P.
Fig. 10 is a view illustrating a state where gripping mechanism 40 pushes in lead component P.
Fig. 11 is a view illustrating a state where gripping mechanism 40 grips component P1 without lead L.

### Description of Embodiments

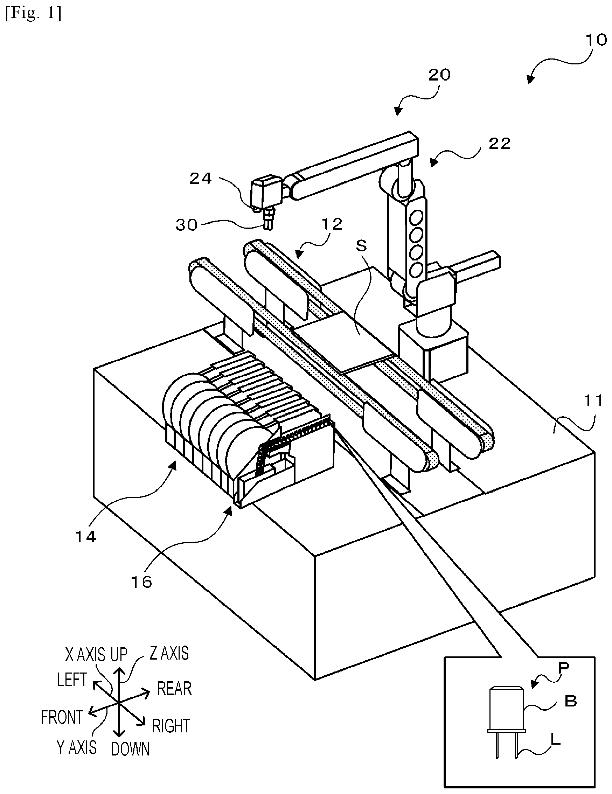

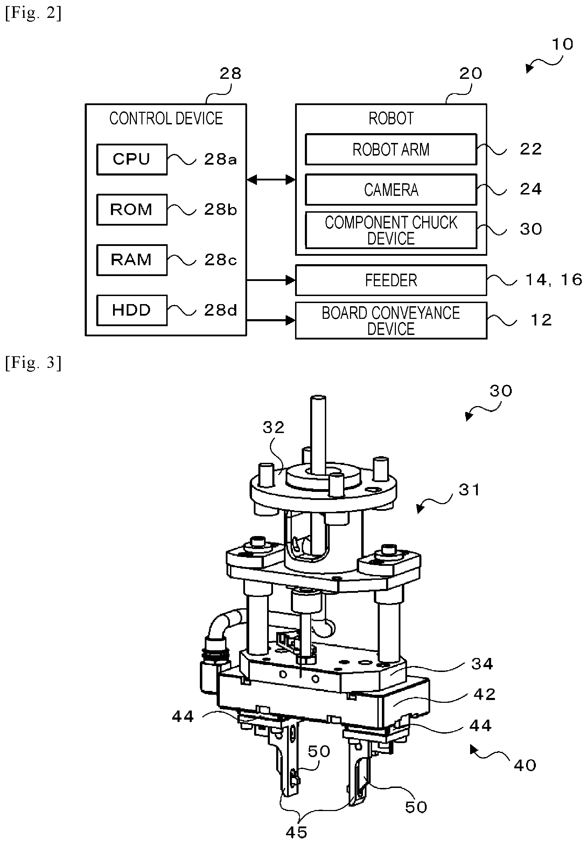

Next, embodiments of the present disclosure will be described with reference to the drawings. Fig. 1 is a configuration diagram illustrating a schematic configuration of work system 10. Fig. 2 is a block diagram illustrating an electrical connection relationship of work system 10. In Fig.1, a left-right direction is an X-axis direction, a front-rear direction is a Y-axis direction, and an up-down direction is a Z-axis direction.

Work system 10 is configured as a system that performs a predetermined work by gripping various components such as mechanical components and electronic components by the operation of robot 20 fixed to work table 11. An example of the predetermined work includes mounting work in which a component is mounted on board S.

Board conveyance device 12 that conveys board S and feeders 14 and 16 such as tape feeders that supply components are disposed on work table 11. Board conveyance device 12 has a pair of belt conveyors which are bridged in the left-right direction (X-axis direction) at intervals in the front-rear direction (Y-axis direction), and conveys board S from left to right by the belt conveyor. Feeder 14 feeds a tape, in which multiple components are accommodated at predetermined intervals, rearward (Y-axis direction) to supply the components. Further, feeder 16 feeds the tape, to which lead component P is attached, to supply lead component P. Lead component P includes body B and lead L extending downward from body B, and is supplied in an upright posture with body B being on the upper side by feeder 16. The feeder is not limited to the tape feeder, and may be a tray feeder that supplies a tray in which multiple components are disposed, a bulk feeder that accommodates multiple components in a scattered state and supplies the components while aligning the components, or the like.

Robot 20 includes, for example, vertical articulated robot arm 22, component chuck device 30 as an end effector detachably attached to a tip link of robot arm 22, and camera 24. Robot arm 22 is provided with a servo motor, an encoder that detects a rotation angle, and the like, which are not illustrated, at each joint. Although details will be described later, component chuck device 30 grips a component by a pair of openable and closable gripping claws 45 (refer to Fig. 3). Camera 24 captures an image for recognizing the position and the posture of the component supplied from feeders 14 and 16, or captures an image for recognizing the position of board S conveyed by board conveyance device 12. Although an example is given of a vertical articulated robot as robot 20, a horizontal articulated robot, an XY robot, or the like may be used.

As illustrated in Fig. 2, control device 28 is configured as a microprocessor that is made up mainly of CPU 28a, and includes, in addition to CPU 28a, ROM 28b that stores various control programs, RAM 28c used as a work area, HDD 28d that stores various data, an input and output port (not illustrated), and the like. Detection signals from sensors (not illustrated) provided in board conveyance device 12, feeders 14 and 16, and robot 20, images captured by camera 24, and the like are input to control device 28. Control device 28 outputs control signals to board conveyance device 12, feeders 14 and 16, robot 20 (robot arm 22 and component chuck device 30), camera 24, and the like.

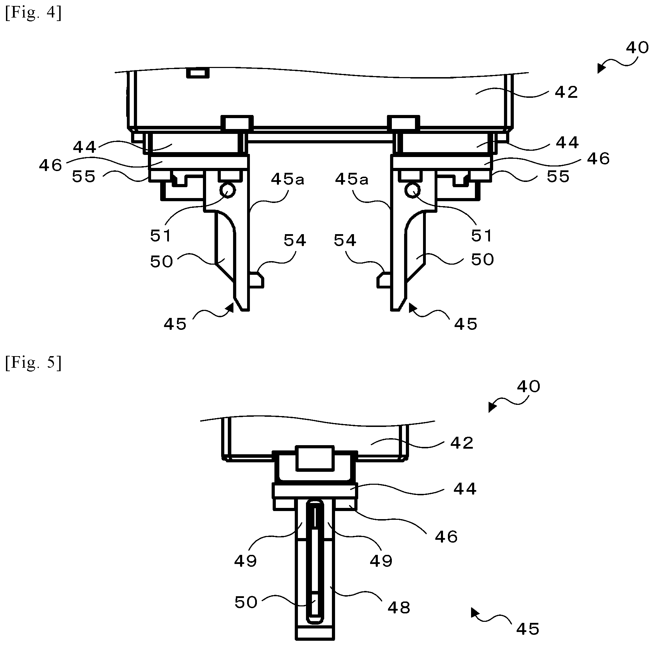

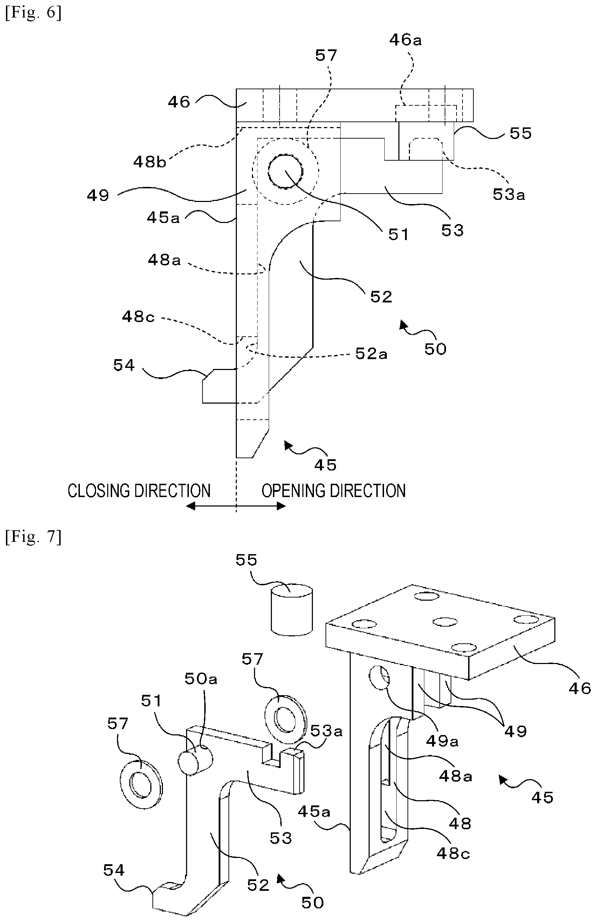

Hereinafter, the configuration of component chuck device 30 will be described. Fig. 3 is a perspective view of component chuck device 30. Fig. 4 is a front view of gripping mechanism 40. Fig. 5 is a side view of gripping mechanism 40. Fig. 6 is a front view of gripping claw 45 integrated with strip 50. Fig. 7 is an exploded perspective view of gripping claw 45 and strip 50.

Component chuck device 30 includes main body portion 31 and gripping mechanism 40 that grips a component by gripping claws 45. In main body portion 31, fixed portion 32 to be fixed to the tip link of robot arm 22 by a bolt or the like is provided in an upper part, and support portion 34 that supports gripping mechanism 40 is provided in a lower part. Main body portion 31 accommodates a signal line that transmits a drive signal to an actuator of opening and closing device 42 of gripping mechanism 40, a supply line that supplies air or electric power to an actuator, and the like.

Gripping mechanism 40 includes opening and closing device 42, a pair of gripping claws 45, a pair of strips 50 respectively supported by each of gripping claws 45, and two springs 55 respectively biasing each of strips 50. Opening and closing device 42 slides a pair of sliders 44 to come close to or space apart from each other by driving an actuator such as an air cylinder or a motor. In opening and closing device 42, the position of slider 44 is detectable by a position sensor such as an encoder. Gripping claw 45 is attached to each of the pair of sliders 44. Opening and closing device 42 moves the pair of gripping claws 45 in the closing direction (inward) to come close to each other or move the pair of gripping claws 45 in the opening direction (outward) to space apart from each other by driving the actuator, thereby opening and closing the pair of gripping claws 45.

Gripping claw 45 is provided to extend downward from flat plate-shaped attachment portion 46 attached to slider 44, and is formed with a smaller width at the lower end side (tip side) than at the upper end side (base end side) in a front view, and gripping surface 45a that grips a component is formed to be a continuous plane from the upper end side to the lower end side. Further, gripping claw 45 is formed in a bifurcated shape to form groove portion 48 extending linearly in the up-down direction on the side opposite to gripping surface 45a. Groove portion 48 is formed to extend from the upper end side to the lower end side in the center of gripping claw 45 in the width direction (left-right direction in Fig. 5). Groove portion 48 is formed to have a width slightly larger than the thickness of strip 50 to be able to accommodate a part of strip 50. In gripping claw 45, support holes 49a for supporting strip 50 are formed in side walls 49 on both sides of groove portion 48. In groove portion 48, bottom surface 48a of the groove is formed substantially in the center in the up-down direction, and through holes 48b and 48c which penetrate to gripping surface 45a are formed on the upper side and the lower side of bottom surface 48a, respectively.

Strip 50 is an inverted L-shaped member in a front view, and is formed such that first extending portion 52 extending downward and second extending portion 53 extending in a horizontal direction are orthogonal to each other. Further, in strip 50, support shaft 51 is attached to shaft hole 50a formed in the bent portion of the inverted L shape, and abutment portion 54, which extends from the lower end side of first extending portion 52 in the direction opposite to second extending portion 53 to be shorter than second extending portion 53 and is configured to abut against the upper surface of a component, is provided.

Strip 50 is inserted into groove portion 48 of gripping claw 45 such that sliding ring 57 is sandwiched between strip 50 and side wall 49. Then, support shaft 51 is inserted in a state where support hole 49a, shaft hole 50a, and the center hole of sliding ring 57 communicate with each other, and thereby pivotally supporting strip 50 by gripping claw 45. That is, strip 50 of the present embodiment is supported by gripping claw 45 to be swingable (rotatable) around support shaft 51.

Spring 55 is a coil spring and is attached to protruding portion 53a formed at an extending end of second extending portion 53 of strip 50. Recessed portion 46a (refer to Fig. 6) into which spring 55 can be fitted is formed in the lower surface of attachment portion 46 of gripping claw 45. Spring 55 biases the extending end of second extending portion 53 of strip 50 downward using the bottom surface of recessed portion 46a as a spring receiver.

In the present embodiment, a part of strip 50 (first extending portion 52) is accommodated in groove portion 48 in a state where gripping claw 45 supports strip 50. Further, second extending portion 53 extends in the opening direction with respect to support shaft 51, and the extending end of second extending portion 53 is biased downward due to spring 55. Therefore, strip 50 swings in a rotation direction in which second extending portion 53 is to be lowered around support shaft 51 as a fulcrum, that is, in a direction in which abutment portion 54 protrudes from gripping surface 45a. Therefore, abutment portion 54 of strip 50 is inserted through hole 48c on the lower side of groove portion 48 and protrudes in the closing direction with respect to gripping surface 45a. However, since bottom surface 48a of groove portion 48 of gripping claw 45 abuts against strip 50 from the side to support side surface 52a of first extending portion 52, the swing of strip 50 in the direction in which abutment portion 54 protrudes from gripping surface 45a is restricted. Therefore, strip 50 remains stationary in the state illustrated in Fig. 6. Strip 50 is configured such that the lower surface of abutment portion 54 is horizontal in a stationary state. In the present embodiment, gripping claw 45 and abutment portion 54 are configured such that abutment portion 54 protrudes in the closing direction above the lower end of gripping surface 45a.

Hereinafter, the operation of component chuck device 30 will be described. Here, an example is given of lead component P having lead L as a grip target component.

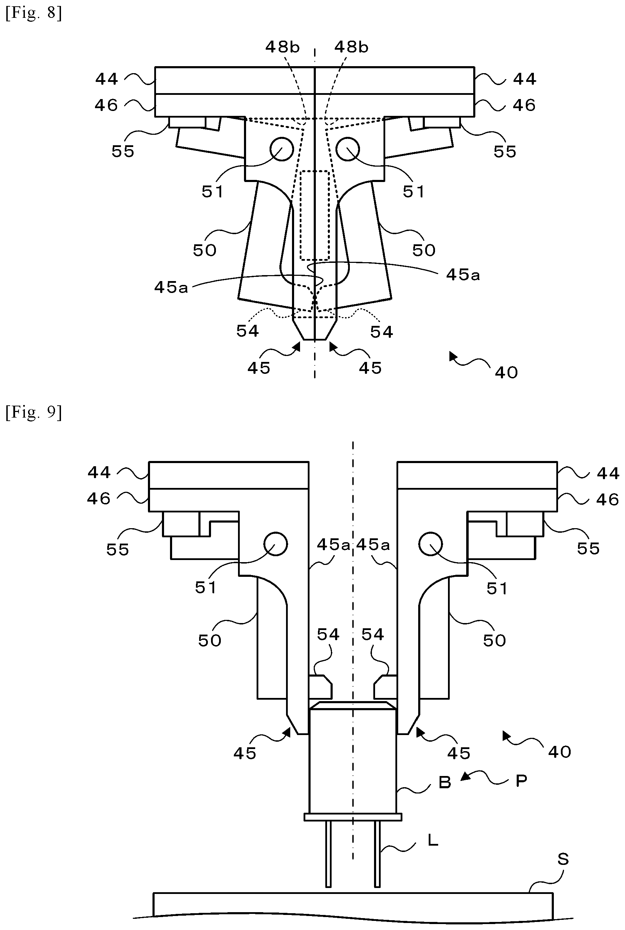

Fig. 8 is a view illustrating a state of gripping mechanism 40 when gripping claws 45 are in a closed state. As illustrated in Fig.8, in a closed state, gripping surfaces 45a of a pair of gripping claws 45 abut against each other. In addition, in strips 50 respectively supported by each of gripping claws 45, opposing abutment portions 54 abut against each other and a force in an opening direction (outward) is exerted on each other. Therefore, each strip 50 swings around support shaft 51 such that abutment portion 54 moves in the opening direction, resisting the biasing force of spring 55, and abutment portion 54 is accommodated and embedded along the opening direction with respect to gripping surface 45a. As described above, even when abutment portion 54 can protrude from gripping surface 45a, since abutment portion 54 does not protrude from gripping surface 45a when gripping claws 45 are in the closed state, gripping surfaces 45a can abut against each other to ensure the closed state. Therefore, control device 28 can detect that gripping claws 45 do not grip a component by detecting the positions of sliders 44 in the closed state with the position sensor. When strip 50 swings as illustrated in Fig. 8, through hole 48b on the upper side of groove portion 48 functions as a relief hole of the bent portion of strip 50.

Fig. 9 is a view illustrating a state where gripping mechanism 40 grips lead component P. As illustrated in Fig. 9, gripping mechanism 40 (opening and closing device 42) grips body B of lead component P in an open state where a pair of gripping claws 45 are moved to a position according to the size of lead component P (body B). Since a force in the opening direction is not exerted on abutment portion 54 when gripping claws 45 are in the open state, abutment portion 54 of strip 50 is in a state of protruding in the closing direction with respect to gripping surface 45a. Gripping mechanism 40 grips body B of lead component P in an area of gripping surface 45a below abutment portion 54 in gripping claw 45.

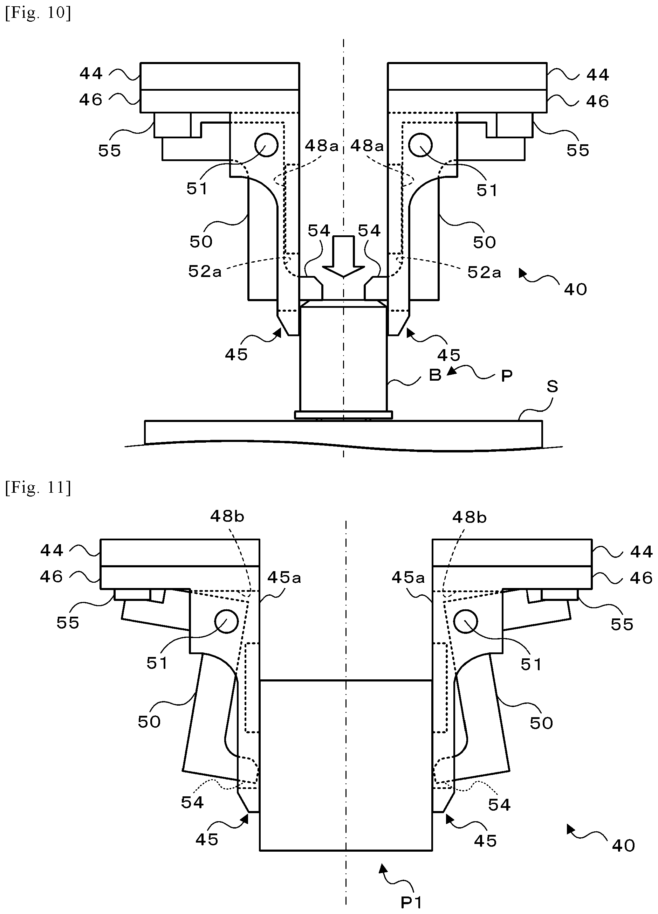

Fig. 10 is a view illustrating a state where gripping mechanism 40 pushes in lead component P. Here, control device 28 moves gripping mechanism 40 (component chuck device 30) such that lead L of lead component P is positioned above a lead hole (not illustrated) formed in board S, and then causes robot arm 22 to move gripping mechanism 40 downward. As gripping mechanism 40 moves downward, the upper surface of lead component P (body B) can be pushed in by abutment portion 54 of strip 50 to push lead L in the lead hole.

Here, as described above, since the swing of strip 50 is restricted by abutting against bottom surface 48a of groove portion 48, even when receiving an upward reaction force when lead component P is pushed in, abutment portion 54 does not move upward (in the closing direction), and the position in the up-down direction is maintained. Therefore, gripping mechanism 40 can securely push in lead component P. In addition, as illustrated in Fig. 9, since gripping mechanism 40 grips body B of lead component P in an area of gripping surface 45a below abutment portion 54, the push-in operation can be started without changing the gripping of lead component P. Since abutment portion 54 of strip 50 can abut against and push in the upper surface of lead component P (body B), regardless of the size of lead component P, versatility of strip 50 is high.

Fig. 11 is a view illustrating a state where gripping mechanism 40 grips component P1 without lead L. As illustrated in Fig. 11, by abutting abutment portion 54 of strip 50 against the side surface of component P1, a force in the opening direction is exerted on abutment portion 54. Therefore, strip 50 swings in a direction in which abutment portion 54 is accommodated along the opening direction with respect to gripping surface 45a, resisting the biasing force of spring 55, and abutment portion 54 is embedded in gripping surface 45a. In this manner, by embedding abutment portion 54 in gripping surface 45a, it is possible to grip component P1 in any area of gripping surface 45a, regardless of strip 50 (abutment portion 54). That is, even when gripping claw 45 and strip 50 are integrally configured, it is possible to prevent restrictions from occurring in gripping a component.

Here, a correspondence relationship between the elements of the present embodiment and the elements of the present disclosure will be clarified. In the present embodiment, gripping claw 45 corresponds to a gripping claw, opening and closing device 42 corresponds to an opening and closing device, strip 50 corresponds to a strip, and gripping mechanism 40 corresponds to a gripping mechanism. Spring 55 corresponds to a biasing member. Groove portion 48 corresponds to a groove portion, bottom surface 48a corresponds to a bottom surface, and through hole 48c corresponds to a through hole.

As described above, in gripping mechanism 40 of the present disclosure, strip 50 is configured to move integrally with gripping claw 45, and is configured such that abutment portion 54 protrudes in the closing direction with respect to gripping surface 45a in an open state of gripping claws 45. Accordingly, even when gripping claws 45 move to any positions according to the size of the component to be gripped, abutment portion 54 can be abutted against the upper surface of the component to push in the component. Therefore, the versatility of strip 50 can be enhanced, and the exchange operation of strip 50 can be reduced.

In addition, since abutment portion 54 of strip 50 is embedded in gripping surface 45a when a force in the opening direction is exerted on abutment portion 54, gripping claws 45 can be fully closed, so that gripping surfaces 45a abut against each other, or can grip a component at a portion of gripping surface 45a where abutment portion 54 protrudes.

In addition, with a simple configuration in which strip 50 is pivotally supported by gripping claw 45 to be swingable around an axis, abutment portion 54 can be made to protrude from or embed in gripping surface 45a.

In addition, since spring 55 is provided to bias strip 50 such that strip 50 swings in a direction in which abutment portion 54 protrudes from gripping surface 45a, it is possible to prevent abutment portion 54 from being unable to protrude due to an operation failure or the like.

In gripping claw 45, groove portion 48 is formed on the opposite side from gripping surface 45a, and strip 50 is pivotally supported on side wall 49 of groove portion 48 to be swingable around an axis. Groove portion 48 includes bottom surface 48a which abuts against strip 50 from the side, and is formed with through hole 48c which penetrates to gripping surface 45a such that abutment portion 54 is inserted. Therefore, it is possible to provide a compact configuration in which strip 50 is accommodated in the width direction of gripping claw 45. In addition, even when an upward force is exerted on abutment portion 54 when a component is pushed in, since bottom surface 48a of groove portion 48 restricts the swing of strip 50, so that the position of abutment portion 54 in the up-down direction is maintained, the component can be securely pushed in. In addition, since gripping claws 45 grip lead component P in an area of gripping surface 45a below a portion where abutment portion 54 protrudes, lead component P can be pushed in by abutment portion 54 without changing the grip.

Needless to say, the present disclosure is not limited to the embodiment that has been described heretofore in any way, and hence can be carried out in various manners without departing from the scope of the claims appended to the present disclosure.

In the embodiment described above, gripping claw 45 is bifurcated to form groove portion 48, and a part (first extending portion 52) of strip 50 is accommodated in groove portion 48, thereby accommodating strip 50 in the width direction of gripping claw 45, but the embodiment is not limited thereto. For example, strip 50 may be configured to be pivotally supported on both outer sides of gripping claw 45 in the width direction. When configured in this way, there is no need to form groove portion 48 by making gripping claw 45 bifurcated. Alternatively, gripping claw 45 may be accommodated between two abutment portions 54 protruding from both outer sides of gripping claw 45 by making strip 50 bifurcated.

In the embodiment, through hole 48b functioning as the relief hole is formed in the upper part of groove portion 48, but through hole need not be formed when the depth of the groove is a depth sufficient to function as the relief hole.

In the embodiment, spring 55 that biases strip 50 is provided, but the present embodiment is not limited thereto, and strip 50 may be swung by its own weight without providing spring 55, or may be swung by attaching a weight or the like.

In the embodiment, strip 50 is configured to be swingable, but the present embodiment is not limited thereto. For example, strip 50 may be a pin member in which abutment portion 54 at the tip end of strip 50 is biased to protrude in the closing direction from gripping surface 45a by a biasing member such as a spring, and when a force in the opening direction is exerted, abutment portion 54 is embedded in gripping surface 45a, resisting the biasing force of the biasing member. That is, strip 50 may be configured to be movable in the horizontal direction such that abutment portion 54 at the tip end protrudes in the closing direction or is embedded in the opening direction with respect to gripping surface 45a.

In the embodiment, strip 50 is supported by gripping claw 45, but the present embodiment is not limited thereto, and strip 50 may be supported by attachment portion 46 or slider 44.

In the embodiment, an example is given where a pair of gripping claws 45 are provided, but the present embodiment is not limited thereto. For example, the present embodiment may be provided with multiple gripping claws 45, such as multiple pairs of gripping claws 45, three or more gripping claws 45 arranged alternately, or three or more gripping claws 45 arranged radially with respect to the gripping center. Further, the present embodiment is not limited to the one in which strip 50 is attached to all of multiple gripping claws 45, and strip 50 need not be attached to some of multiple gripping claws 45.

In the embodiment, an example is given where lead component P is pushed in by strip 50, but the present embodiment is not limited thereto, and strip 50 (abutment portion 54) may abut against the upper surface of a component in order to adjust the height position when the component is gripped.

Although strip 50 of the embodiment is configured to abut against the upper surface of a component regardless of the size of the component and has high versatility, strip 50 may be replaced according to the size or shape of the component. For example, strip 50 selected from among multiple types of strips 50 that differ in the length at which abutment portion 54 protrudes from gripping surface 45a and the position of protruding portion in the up-down direction may be attached.

Here, the gripping mechanism of the present disclosure may be configured as follows. For example, in the gripping mechanism of the present disclosure, the strip may be configured such that the abutment portion is accommodated along the opening direction with respect to the gripping surface when a force in the opening direction is exerted on the abutment portion. In this way, even when the abutment portion of the strip is configured to protrude with respect to the gripping surface, the gripping claws can be fully closed, so that the gripping surfaces abut against each other, or can grip a component at a portion of the gripping surface where the abutment portion protrudes.

In the gripping mechanism of the present disclosure, the strip may be pivotally supported by the gripping claw to be swingable around an axis, and may be configured to swing in a direction in which the abutment portion protrudes in the closing direction with respect to the gripping surface when the multiple gripping claws are in the open state and a force in the opening direction is not exerted on the abutment portion, and swing in a direction in which the abutment portion is accommodated along the opening direction with respect to the gripping surface when the multiple gripping claws come close to each other to be in a closed state and a force in the opening direction is exerted on the abutment portion. In this way, the abutment portion of the strip can be made to protrude from or accommodate in the gripping surface with a simple configuration.

The gripping mechanism of the present disclosure may further include a biasing member configured to bias the strip such that the strip swings in a direction in which the abutment portion protrudes in the closing direction with respect to the gripping surface. In this way, it is possible to prevent the abutment portion from being unable to protrude due to an operation failure or the like.

In the gripping mechanism of the present disclosure, in the gripping claw, a groove portion extending in an up-down direction to accommodate at least a part of the strip may be formed in a center in a width direction on a side opposite to the gripping surface, the strip may be pivotally supported on a side wall of the groove portion such that an upper end side is swingable around an axis, and includes the abutment portion that is provided on a lower end side to extend in the closing direction, and the groove portion may include a bottom surface which abuts against the strip from a side and may be formed with a through hole which penetrates to the gripping surface such that the abutment portion is inserted into a part of the bottom surface. In this way, a compact configuration in which the strip is accommodated in the width direction of the gripping claw can be obtained. In addition, even when an upward force is exerted on the abutment portion when a component is pushed in, since the bottom surface of the groove portion restricts the swing by abutting against the strip from the side, so that the position of the abutment portion is maintained, the component can be securely pushed in.

In the gripping mechanism of the present disclosure, the abutment portion of the strip may protrude in the closing direction above a lower end of the gripping surface, and the gripping claw may be configured to grip a component in an area of the gripping surface below the abutment portion. In this way, since the abutment portion protrudes above the component gripped by the gripping surface, the gripped component can be pushed in without changing the grip.

### Industrial Applicability

The present disclosure is applicable to a technical field of devices for gripping a component.

### Reference Signs List

10: work system, 11: work table, 12: board conveyance device, 14, 16: feeder, 20: robot, 22: robot arm, 24: camera, 28: control device, 28a: CPU, 28b: ROM, 28c: RAM, 28d: HDD, 30: component chuck device, 31: main body portion, 32: fixed portion, 34: support portion, 40: gripping mechanism, 42: opening and closing device, 44: slider, 45: gripping claw, 45a: gripping surface, 46: attachment portion, 46a: recessed portion, 48: groove portion, 48a: bottom surface, 48b, 48c: through hole, 49: side wall, 49a: support hole, 50: strip, 50a: shaft hole, 51: support shaft, 52: first extending portion, 52a: side surface, 53: second extending portion, 53a: protruding portion, 54: abutment portion, 55: spring, 57: sliding ring, B: body, L: lead, P: lead component, P1: component

## Claims

1. A gripping mechanism (40) comprising:
multiple gripping claws (45) configured to grip a component (P, P1);
an opening and closing device (42) configured to move the multiple gripping claws (45) in an opening direction in which the multiple gripping claws (45) are spaced apart from each other and in a closing direction in which the multiple gripping claws (45) come close to each other; and
multiple strips (50) including abutment portions (54) configured to abut against an upper surface of the component (P, P1),
wherein the strip (50) is configured to move integrally with the gripping claw (45), and is configured such that the abutment portion (54) protrudes in the closing direction with respect to a gripping surface (45a) of the gripping claw (45) in an open state where the multiple gripping claws (45) are spaced apart from each other,
**characterized in that**
the strip (50) is configured such that the abutment portion (54) is accommodated along the opening direction with respect to the gripping surface (45a) when a force in the opening direction is exerted on the abutment portion (54).

2. The gripping mechanism (40) according to claim 1,
wherein the strip (50) is pivotally supported by the gripping claw (45) to be swingable around an axis, and is configured to swing in a direction in which the abutment portion (54) protrudes in the closing direction with respect to the gripping surface (45a) when the multiple gripping claws (45) are in the open state and a force in the opening direction is not exerted on the abutment portion (54), and swing in a direction in which the abutment portion (54) is accommodated along the opening direction with respect to the gripping surface (45a) when the multiple gripping claws (45) come close to each other to be in a closed state and a force in the opening direction is exerted on the abutment portion (54).

3. The gripping mechanism (40) according to claim 2, further comprising a biasing member (55) configured to bias the strip (50) such that the strip (50) swings in a direction in which the abutment portion (54) protrudes in the closing direction with respect to the gripping surface (45a).

4. The gripping mechanism (40) according to any one of claims 1 to 3, wherein
in the gripping claw (45), a groove portion (48) extending in an up-down direction to accommodate at least a part of the strip (50) is formed in a center in a width direction on a side opposite to the gripping surface (45a),
the strip (50) is pivotally supported on a side wall (49) of the groove portion (48) such that an upper end side is swingable around an axis, and includes the abutment portion (54) that is provided on a lower end side to extend in the closing direction, and
the groove portion (48) includes a bottom surface (48a) which abuts against the strip (50) from a side and is formed with a through hole (48c) which penetrates to the gripping surface (45a) such that the abutment portion (54) is inserted into a part of the bottom surface (48a).

5. The gripping mechanism (40) according to any one of claims 1 to 4, wherein
the abutment portion (54) of the strip (50) protrudes in the closing direction above a lower end of the gripping surface (45a), and
the gripping claw (45) is configured to grip a component (P, P1) in an area of the gripping surface (45a) below the abutment portion (54).

## Patentansprüche

1. Greifmechanismus (40), umfassend:
mehrere Greifklauen (45), die dazu konfiguriert sind, um ein Bauteil (P, P1) zu greifen;
eine Öffnungs- und Schließvorrichtung (42), die konfiguriert ist, um die mehreren Greifklauen (45) in eine Öffnungsrichtung, in der die mehreren Greifklauen (45) voneinander entfernt sind, und in eine Schließrichtung, in der die mehreren Greifklauen (45) einander nahe kommen, zu bewegen; und
mehrere Streifen (50) mit Anschlagabschnitten (54), die konfiguriert sind, um an einer oberen Fläche des Bauteils (P, P1) anzuliegen,
wobei der Streifen (50) so konfiguriert ist, dass er sich integral mit der Greifklaue (45) bewegt, und so konfiguriert ist, dass der Anschlagabschnitt (54) in einem offenen Zustand, in dem die mehreren Greifklauen (45) voneinander entfernt sind, in Bezug auf eine Greiffläche (45a) der Greifklaue (45) in der Schließrichtung vorsteht,
**dadurch gekennzeichnet, dass**
der Streifen (50) so ausgebildet ist, dass der Anschlagabschnitt (54) in Bezug auf die Greiffläche (45a) in der Öffnungsrichtung aufgenommen wird, wenn auf den Anschlagabschnitt (54) eine Kraft in der Öffnungsrichtung ausgeübt wird.

2. Greifmechanismus (40) nach Anspruch 1,
wobei der Streifen (50) drehbar von der Greifklaue (45) getragen wird, so dass er um eine Achse schwenkbar ist, und so konfiguriert ist, dass er in eine Richtung schwenkt, in der der Anschlagabschnitt (54) in Bezug auf die Greiffläche (45a) in der Schließrichtung vorsteht, wenn sich die mehreren Greifklauen (45) im offenen Zustand befinden und keine Kraft in der Öffnungsrichtung auf den Anschlagabschnitt (54) ausgeübt wird, und in eine Richtung schwenkt, in der der Anschlagabschnitt (54) in Bezug auf die Greiffläche (45a) entlang der Öffnungsrichtung aufgenommen ist, wenn die mehreren Greifklauen (45) einander nahe kommen, um in einem geschlossenen Zustand zu sein, und eine Kraft in der Öffnungsrichtung auf den Anschlagabschnitt (54) ausgeübt wird.

3. Greifmechanismus (40) nach Anspruch 2, der femer ein Vorspannelement (55) umfasst, das dazu konfiguriert ist, den Streifen (50) so vorzuspannen, dass der Streifen (50) in eine Richtung schwingt, in der der Anschlagabschnitt (54) in Bezug auf die Greiffläche (45a) in der Schließrichtung vorsteht.

4. Greifmechanismus (40) nach einem der Ansprüche 1 bis 3, wobei
in der Greifklaue (45), in der Mitte in einer Breitenrichtung auf einer der Greiffläche (45a) gegenüberliegenden Seite ein sich in Aufwärts-Abwärts-Richtung erstreckender Nutabschnitt (48) zur Aufnahme zumindest eines Teils des Streifens (50) ausgebildet ist,
der Streifen (50) an einer Seitenwand (49) des Nutabschnitts (48) drehbar getragen wird, so dass eine obere Endseite um eine Achse schwenkbar ist, und er den Anschlagabschnitt (54) aufweist, der an einer unteren Endseite vorgesehen ist, und sich in der Schließrichtung erstreckt, und
der Nutabschnitt (48) eine Bodenfläche (48a) aufweist, die von einer Seite an den Streifen (50) anliegt und mit einem Durchgangsloch (48c) ausgebildet ist, das bis zur Greiffläche (45a) durchdringt, so dass der Anschlagabschnitt (54) in einen Teil der Bodenfläche (48a) eingeführt ist.

5. Greifmechanismus (40) nach einem der Ansprüche 1 bis 4, wobei
der Anschlagabschnitt (54) des Streifens (50) in der Schließrichtung über einem unteren Ende der Greiffläche (45a) hinausragt, und
die Greifklaue (45) dazu konfiguriert ist, um ein Bauteil (P, P1) in einem Bereich der Greiffläche (45a) unterhalb des Anschlagabschnitts (54) zu greifen.

## Revendications

1. Mécanisme de préhension (40) comprenant
plusieurs griffes de préhension (45) configurées pour saisir un composant (P, P1);
un dispositif d'ouverture et de fermeture (42) configuré pour déplacer les multiples griffes de préhension (45) dans une direction d'ouverture dans laquelle les multiples griffes (45) sont espacées l'une de l'autre et dans une direction de fermeture dans laquelle les multiples griffes de préhension (45) se rapprochent l'une de l'autre ; et
plusieurs bandes (50) comprenant des parties de butée (54) configurées pour s'appuyer contre une surface supérieure du composant (P, P1),
dans lequel la bande (50) est configurée pour se déplacer intégralement avec la griffe de préhension (45), et est configurée de telle sorte que la partie de butée (54) fait saillie dans la direction de fermeture par rapport à une surface de préhension (45a) de la griffe de préhension (45) dans un état ouvert où les multiples griffes de préhension (45) sont espacées l'une de l'autre,
**caractérisé par le fait que**
la bande (50) est configurée de telle sorte que la partie de butée (54) est logée le long de la direction d'ouverture par rapport à la surface de préhension (45a) lorsqu'une force dans la direction d'ouverture est exercée sur la partie de butée (54).

2. Mécanisme de préhension (40) selon la revendication 1,
dans lequel la bande (50) est supportée de manière pivotante par la griffe de préhension (45) pour pouvoir pivoter autour d'un axe, et est configurée pour pivoter dans une direction dans laquelle la partie de butée (54) fait saillie dans la direction de fermeture par rapport à la surface de préhension (45a) lorsque les multiples griffes de préhension (45) sont à l'état ouvert et qu'une force dans la direction d'ouverture n'est pas exercée sur la partie de butée (54), et osciller dans une direction dans laquelle la partie de butée (54) est logée le long de la direction d'ouverture par rapport à la surface de préhension (45a) lorsque les multiples griffes de préhension (45) se rapprochent l'une de l'autre pour être dans un état fermé et qu'une force dans la direction d'ouverture est exercée sur la partie de butée (54).

3. Mécanisme de préhension (40) selon la revendication 2, comprenant en outre un élément de sollicitation (55) configuré pour solliciter la bande (50) de manière à ce que la bande (50) pivote dans une direction dans laquelle la partie de butée (54) fait saillie dans la direction de fermeture par rapport à la surface de préhension (45a).

4. Mécanisme de préhension (40) selon l'une quelconque des revendications 1 à 3, dans lequel
dans la griffe de préhension (45), une partie de la rainure (48) s'étendant dans le sens haut-bas pour accueillir au moins une partie de la bande (50) est formée au centre dans le sens de la largeur sur un côté opposé à la surface de préhension (45a),
la bande (50) est supportée de manière pivotante sur une paroi latérale (49) de la partie rainurée (48) de sorte qu'une extrémité supérieure puisse pivoter autour d'un axe, et comprend la partie de butée (54) qui est fournie sur une extrémité inférieure pour s'étendre dans la direction de fermeture, et
la partie rainurée (48) comprend une surface inférieure (48a) qui s'appuie contre la bande (50) d'un côté et est formée d'un trou traversant (48c) qui pénètre dans la surface de préhension (45a) de telle sorte que la partie de butée (54) est insérée dans une partie de la surface inférieure (48a).

5. Mécanisme de préhension (40) selon l'une quelconque des revendications 1 à 4, dans lequel
la partie de butée (54) de la bande (50) fait saillie dans la direction de fermeture au-dessus d'une extrémité inférieure de la surface de préhension (45a), et
la griffe de préhension (45) est configurée pour saisir un composant (P, P1) dans une zone de la surface de préhension (45a) située en dessous de la partie de butée (54).
